# EUROPEAN PATENT APPLICATION

(11) **EP 1 898 452 A1**
(43) Date of publication of application: **12.03.2008**
(21) Application number: 07101925.1
(22) Date of filing: 07.02.2007
(51) Int. Cl.: H01L 21/285

(54) **Method for forming germandies and devices obtained thereof**

(30) Priority: 08.09.2006 US 517654
(71) Applicant: Interuniversitair Microelektronica Centrum (IMEC), 3001 Leuven (BE); Intel Corporation (INTEL), Santa Clara, CA 95052-8119 (US); Katholieke Universiteit Leuven (KUL), 3000 Leuven (BE)
(72) Inventor: Brunco, David, 3080 Tervuren (BE); Opsomer, Karl, 9890 Gavere (BE); De Jaeger, Brice, 3001 Leuven (BE)
(74) Representative: pronovem

(57) **Abstract**

The present invention discloses a method for forming germanides on substrates with exposed germanium and exposed dielectric(s) topography, thereby allowing for variations in the germanide forming process.

The method comprises the steps of depositing nickel on a substrate having topography, performing a first thermal step to convert substantially all deposited nickel in regions away from the topography into a germanide, selectively removing the unreacted nickel, and performing a second thermal step to lower the resistance of formed germanide.

## Description

### Field of the Invention

The present invention is related to the field of semiconductor processing and, more particularly, to the formation of low resistance layers on germanium substrates.

### Background of the Invention

An approach for modifying the electrical properties of a semiconductor element (e.g. to reduce the resistivity of a semiconductor region in a substrate) is to deposit a metal over at least the particular semiconductor element.

The stack that includes the metal and the semiconductor material is then heated to produce a semiconductor-metal compound layer.

This layer has a lower resistivity than the resistivity of the starting semiconductor material.

Unreacted metal is then removed from the substrate, such as selectively from the semiconductor-metal compound.

Such a process leaves the semiconductor-metal compound layer intact and removes excess unreacted metal from the deposition and heating operations.

A semiconductor-metal compound layer that is obtained by selectively removing unreacted metal without performing any masking step to pattern this compound layer is typically referred to as a self-aligned structure.

In certain embodiments, an additional heating step is performed to further reduce the resistivity of the semiconductor-metal compound layer, e.g. by changing the crystal phase of this layer. Examples of such semiconductor-metal compounds are silicides.

Metal silicide thin films are commonly used in microelectronic circuits in a variety of applications, such as interconnects, contacts and for the formation of transistor gates. For example, titanium disilicide (TiSi₂), cobalt disilicide (CoSi₂), and/or nickel silicide (NiSi) are used in Ultra Large Scale Integration Semiconductor devices having submicron feature sizes. As is known, silicide layers have a lower sheet resistance than the corresponding sheet resistance of the silicon from which they are formed.

Due to its electronic properties, germanium is, for various MOS technologies, considered to be a replacement for silicon as the semiconductor material of choice to form substrates and/or gate electrodes.

Germanides, e.g. compounds resulting from the reaction between germanium and a metal, such as Ni, are used to reduce the resistivity of source and drain regions.

### Summary of the Invention

The present invention provides a semiconductor processing method for preventing defects (or pits) in the formation of a nickel-germanide layer comprising the steps of:
- providing a substrate on which at least one area of a germanium layer is exposed,
- depositing nickel over the substrate and said germanium area,
- performing a first thermal process step by providing a first thermal budget wherein the temperature is higher than 200°C and lower than 325°C, for a time period of less than 600 seconds (preferably comprised between 1 millisecond and 300 seconds), whereby a germanide layer is formed,
- selectively removing unreacted nickel, and
- performing a second thermal process step for which a second thermal budget is provided to lower the resistance of the previously formed germanide layer.

Preferably, in a method of the invention, the temperature of said first thermal budget is higher than 205°C and lower than 300°C, more preferably higher than 210°C and lower than 275°C, even more preferably is comprised between 230°C and 270°C.

Preferably, in a method of the invention, on said substrate, said Ge layer contacts (touches) another exposed area of another material that is suitable in semiconductor processing. Preferably, said material is selected from the group consisting of a dielectric material, a non-germanide forming metal (e.g. TiN or TaN), a polymer capable of withstanding required process temperatures, and a semiconductor material different from Ge that does not react with Ni. More preferably, said other exposed material is a dielectric material, such as SiO₂, Si₃N₄ or a high-k dielectric material (i.e. dielectric material having a higher dielectric constant than SiO₂) such as HfO₂, ZrO₂, or Hf-silicate.

In particular, said dielectric material can be used for or in the form of a field isolation region or a spacer.

Preferably, in a method of the invention, the time period of said first thermal budget is in the range of 10 seconds to 60 seconds.

Preferably, in a method of the invention, said first thermal process step is performed in a thermal processing tool, e.g. a Rapid Thermal Processor (RTP tool) or a diffusion furnace. More preferably, said first thermal process step is performed in an RTP tool.

Preferably, in a method of the invention, said first thermal process step consists of a Rapid Thermal Process(ing) step (RTP step). More particularly, said first thermal process step can consist of a conventional RTP anneal (e.g. anneal time at peak temperature between 1 and 300 seconds), a spike anneal (e.g. anneal with less than about 1 second at peak temperature), or a laser anneal.

Preferably, said first thermal process step is performed in an inert ambient such as nitrogen.

In a method of the invention, said nickel can be in the form of an alloy comprising at least about 50% nickel. More particularly, said alloy can comprise (or consist of) at least 50% nickel and any metal suitable for the manufacture of a semiconductor device, such as cobalt, palladium, platinum, and/or ytterbium. Preferably, in a method of the invention, said nickel is pure.

Preferably, in a method of the invention, said second thermal process step is performed in a thermal processing tool, e.g. a Rapid Thermal Processor (RTP tool) or a diffusion furnace. More preferably, this thermal step is performed in an RTP tool.

Preferably, in a method of the invention, said second thermal process step consists of an RTP step. More particularly, said second thermal process step can consist of a conventional RTP anneal, a spike anneal, or a laser anneal.

Preferably, said second thermal process step is performed in an inert ambient like nitrogen.

Preferably, said second thermal budget is comprised between 280°C and 550°C, more preferably between 300°C and 550°C.

Preferably, the time period of said second thermal budget is in the range of nearly 0 second (e.g. 1 millisecond) to 600 seconds. More particularly, the time period of said second thermal budget is in the range of 1 millisecond to 300 seconds. More preferably, the time period of said second thermal budget is in the range of 10 seconds to 60 seconds.

More preferably, the temperature of the second thermal step is in the range of 325°C to 400°C, for a time period in the range of 10 seconds to 60 seconds.

Also object of the invention is the substrate (or device) obtainable by a method according to the invention, said substrate (or device) comprising a nickel-germanide layer (essentially) free of pits or defects and being (essentially) free of germanide on the adjacent region(s) (i.e. where germanide is not wanted).

### Brief Description of the Drawings

Various embodiments are described herein with reference to the following drawings. Certain aspects of the drawings are depicted in a simplified way for reason of clarity. Not all alternatives and options are shown in the drawings and, therefore, the invention is not limited in scope to the content of the drawings. Like numerals are employed to reference like parts in the different figures.

Figure 1 shows a cross-section of a germanium substrate illustrating a prior art nickel-germanide formation process.

Figure 2 shows a Scanning Electron Microscope (SEM) picture of a nickel-germanide formed at 360°C, 30 sec (as illustrated in Figure 1), obtained according to a prior art process.

Figure 3 is a flowchart illustrating a germanide-forming process according to the invention.

Figures 4a-d illustrate a process flow according to an embodiment by cross-sectional schematic views of subsequent process steps.

Figure 5 shows a SEM picture of a nickel-germanide formed according to the invention.

Figure 6 shows sheet resistance of germanided lines of Ni deposited on Ge as a function of RTP temperature. Sheet resistance was measured using the 4-point probe technique.

### Detailed Description

The following description discusses various embodiments related to self-aligned germanides, and methods for the formation of self-aligned germanides, such as on a germanium layer.

Generally, such self-aligned germanides may be formed by depositing a layer of metal over a substrate and a germanium region, heating the structure to form a compound of the metal and the germanium and selectively removing unreacted metal, e.g. using a selective etching technique.

In the context of the present invention, the term "RTP step" is used in a generic sense, referring to semiconductor device processing, wherein the temperature is rapidly increase, e.g. involving heating rates higher than 10°C/s, and wherein the heating means include, but are not limited to, resistive wiring, halogen lamps, flash lamps, and lasers.

In the context of the present invention, the term "RTP tool" is also used in a generic sense, referring to any semiconductor process tool capable of rapid heating rates (e.g. higher than 10°C/s) including, but not limited to, systems heated by resistive wiring, halogen lamps, flash lamps, and lasers.

The present invention provides a semiconductor processing method for preventing defects (or pits) in the formation of a nickel-germanide layer comprising the steps of:
- providing a substrate on which at least one area of a germanium layer is exposed,
- depositing nickel over the substrate and said germanium area,
- performing a first thermal process step by providing a first thermal budget wherein the temperature is higher than 200°C and lower than 325°C, for a time period of less than 600 seconds, preferably comprised between 1 millisecond and 300 seconds, whereby a germanide layer is formed,
- selectively removing unreacted nickel, and
- performing a second thermal process step for which a second thermal budget is provided to lower the resistance of the previously formed germanide layer.

In particular, said method comprises providing a substrate comprising an exposed germanium area bordering (contacting) a dielectric area; depositing nickel over the substrate; performing a first thermal process step for which a first thermal budget is selected to convert, in center regions of the germanium area, substantially all metal into a nickel-germanide; selectively removing unreacted metal; and performing a second thermal process step for which a second thermal budget is selected to lower the resistance of the formed germanide layer, wherein providing said first thermal budget consist of applying a temperature higher than 200°C and lower than 325°C (each temperature being envisaged within that range), for a time period of less than 600 seconds, preferably comprised between 1 millisecond, and 300 seconds, more preferably comprised between 10 seconds and 60 seconds.

The dielectric area may be a field isolation region or a spacer.

The germanide layer formed during the first thermal process step may comprise metal-rich germanide and mono-germanide phases.

Preferably, the germanide-forming metal comprises nickel, and in particular more than 50% nickel. More preferably, the germanide-forming metal consists of nickel.

Preferably, said first thermal process step is performed in a thermal processing tool, e.g. as an RTP tool or a batch furnace, such as a horizontal or vertical diffusion furnace. More preferably, said first thermal process step is performed in an RTP tool.

Preferably, the temperature of said first thermal step is in the range of 205°C to 325°C, for a time period in the range of nearly 0 seconds (e.g. 1 millisecond) to 300 seconds, preferably in the range of 10 seconds to 60 seconds.

More preferably, the temperature of said first thermal step is in the range of 210°C to 275°C, for a time period in the range of nearly 0 seconds (e.g. 1 millisecond) to 300 seconds, preferably in the range of 10 seconds to 60 seconds.

Even more preferably, the temperature of said first thermal step is in the range of 230°C to 270°C, for a time period in the range of nearly 0 seconds (e.g. 1 millisecond) to 300 seconds, preferably in the range of 10 seconds to 60 seconds.

Preferably, said second thermal process step is performed in a thermal processing tool, e.g. as an RTP tool or a batch furnace, such as a horizontal or vertical diffusion furnace. More preferably, said second thermal process step is performed in an RTP tool.

Preferably, the temperature of the second thermal step is in the range of 280°C to 550°C, or more preferably in the range of 300°C to 550°C, for a time period of less than 600 seconds, preferably comprised between 1 millisecond and 300 seconds, whereby the resistance of the germanide layer is reduced to meet required specifications.

More preferably, the temperature of the second thermal step is in the range of 325°C to 400°C, for a time period in the range of 10 seconds to 60 seconds.

In particular, a method for forming a germanide on a substrate according to the invention comprises the steps of:
- providing a substrate comprising an exposed germanium area bordered by (or contacting/touching) a dielectric area;
- depositing nickel over the substrate;
- performing a first thermal process step for which a first thermal budget is selected within the specific temperature range and time according to the present invention,
- selectively removing unreacted nickel; and
- performing a second thermal process step for which a second thermal budget is selected to lower the resistance of the formed nickel-germanide layer.

Said first thermal process allows conversion, in regions of the germanium area away from the dielectric area, substantially all nickel into a nickel-germanide and to limit diffusion of germanium over the dielectric area.

The nickel-germanide formed during the first thermal process step may comprise metal-rich germanide phases (e.g., Ni₅Ge₃ or Ni₂Ge) and the mono-germanide phase (NiGe). The second thermal step completes the reaction such that NiGe is essentially the only remaining germanide phase.

Carrying out a method of the invention results in a substrate, also object of the invention, comprising a nickel-germanide formed on a germanium area bordering a dielectric region, wherein essentially no pits are present in the germanium area near the germanium-dielectric region and essentially no undesirable germanide is present on the dielectric region.

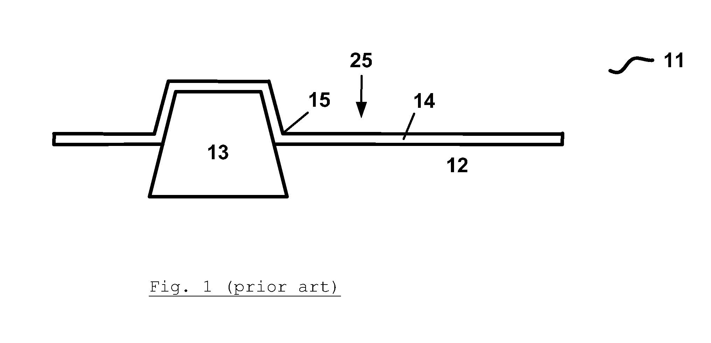

In Figure 1, a cross-section is shown of a germanium substrate comprising active areas and isolation regions illustrating a prior art nickel-germanide formation process.

Over the germanium substrate 11, comprising active areas 12 and isolation regions 13, a nickel layer 14 is deposited.

The substrate 11 is sufficiently heated to have the deposited nickel layer 14 and exposed germanium in the active areas 12 react to form a nickel-germanide layer 16.

Thereafter, the unreacted nickel 14 is selectively removed.

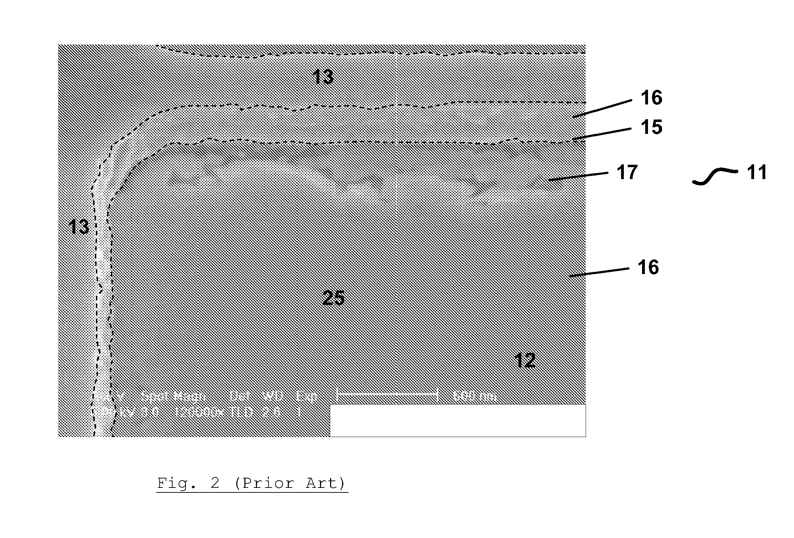

Figure 2 shows a Scanning Electron Microscope (SEM) picture of a nickel-germanide layer formed on a patterned substrate 11 according to the prior art process illustrated in Figure 1.

Black dotted lines have been added to mark the contours of the dielectric region 13, SiO₂ in this case.

About 10 nm of nickel 14 was deposited on a substrate 11 containing exposed germanium surfaces 12 bordered by a dielectric region 13. This substrate was then heated to about 360°C for about 30 sec. Unreacted nickel 14 was selectively wet etched from the substrate 11.

This picture was taken from the germanided surface of the substrate 11, which was tilted to 35°. This picture clearly shows the pits 17 created in the active area 12 near the isolation regions 13, while the germanide 16 in the center 25 of the germanium region 12 remote from the edge 15 appears to be defect-free. Large number of defects can be observed, including pits, in the active germanium layer 12 near the border with the dielectric region 13 and also germanide 16 overgrowth on the isolation 13. The germanide 16 is also formed on the isolation regions 13 as shown by the crystal grains formed on the insulating dielectric.

Reducing the temperature at which the final germanide layer 16 is formed might reduce number and/or size of defects, but not necessarily eliminate these defects. Moreover, reducing the formation temperature of the final germanide layer 16 can result in the germanide resistance being too high for acceptable device performance.

Experiments have shown that the phenomena of pit formation and germanide overgrowth occur during thermal processing of the nickel-covered germanium substrate 11.

The distribution of the pits 17 and the degree of germanide overgrowth over isolation regions 13 at the active area edge 15 depend on the location of the active area 12, in particular on the position of this edge 15, on the germanium substrate 11.

Typically, the defects are formed in the germanium region 12 adjacent to the dielectric region 13. Said adjacent region can also be referred to as the transition region.

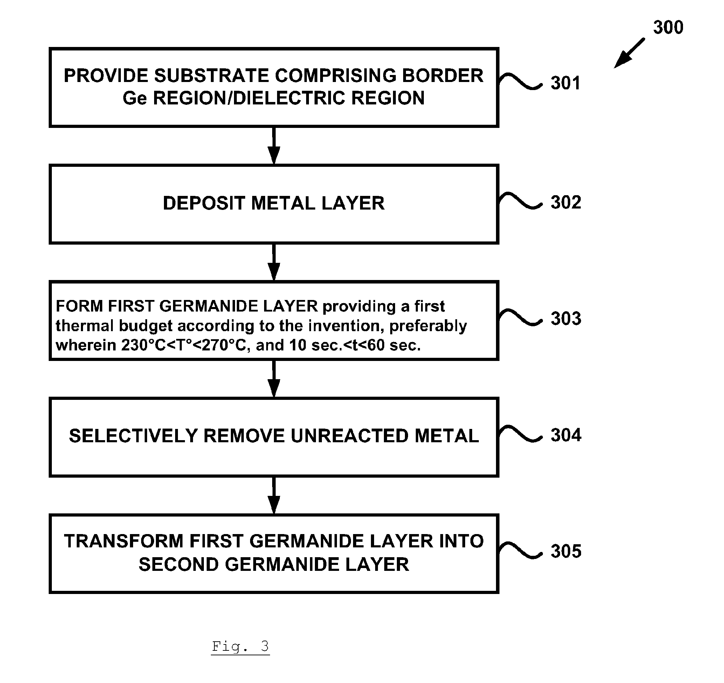

Figure 3 is a flowchart illustrating a process 300 for forming a germanide layer according to the invention.

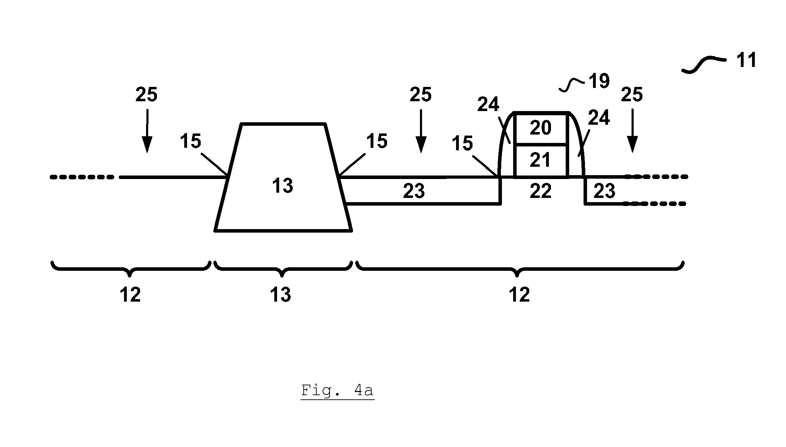

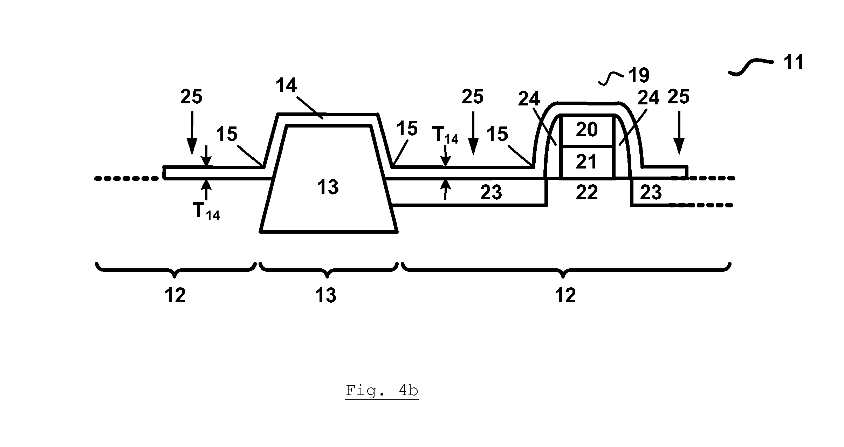

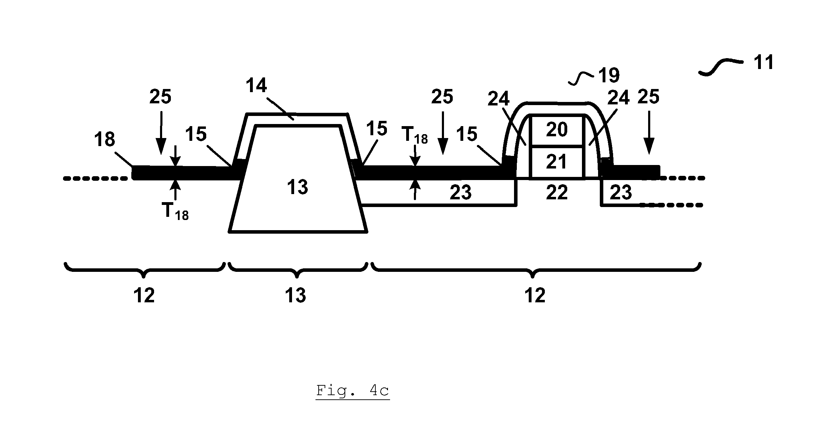

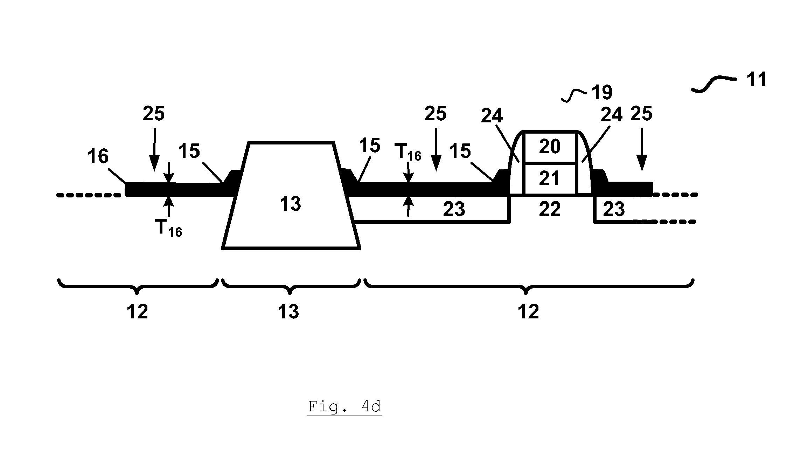

In block 301, and referring to figure 4, a germanium-based substrate 11 is provided. This substrate 11 can be any substrate with a Ge-based active layer 12, including bulk germanium wafers, germanium-on-insulator wafers, and deposited Ge layers 12 on other substrates like silicon.

This substrate 11 further comprises a dielectric pattern 13, 24 bordering (touching) the germanium layer 12. More generally, this germanium-based substrate 11 can be any substrate comprising an exposed germanium region 12 bordering (touching) a dielectric region 13.

A height difference (topographical step) may exist between the exposed surfaces of the germanium region 12 and the dielectric region 13, 24. This substrate 11 can be a patterned wafer comprising germanium active areas 12 separated by isolation regions 13.

The isolation regions 13, also known as field isolation regions, can be formed by one of several techniques such as box isolation or shallow-trench-isolation (STI).

In case of box isolation, openings are formed, by dry or wet etch, in an oxide layer 13 overlying a germanium layer to expose regions 12 of this germanium layer.

In the case of shallow-trench-isolation, grooves 13 formed by dry-etch in the substrate 11 are filled with a dielectric layer providing electrical insulation.

The germanium can be in an amorphous or crystalline state. The germanium of the exposed region 12 can comprise some amount of other materials suitable in semiconductor processing, more particularly semiconductors such as silicon, dopants such as arsenic, phosphorus, antimony, boron, and gallium, or other commonly used elements in semiconductor processing like C and F.

If the germanium region 12 is formed by means of the germanium condensation technique, typically, up to about 15% silicon can be present in the thus formed germanium layer. The U.S. patent application published under No. 2003/0006461 discloses such a method of germanium condensation.

The germanium active area 12 can comprise one or more semiconductor devices. If the semiconductor device is a field-effect-transistor, the germanium active area 12 may comprise a stack of a gate electrode 20 and a gate dielectric 21. This gate stack is formed on the germanium substrate, thereby, defining the channel region.

The gate dielectric 21 can be an oxide, a nitrided oxide, an oxynitride or a high-k dielectric such as a hafnium oxide or an aluminum oxide.

The gate electrode 20 can be formed from a semiconductor material such as polysilicon, silicon-germanium, germanium, or from a metallic material such as TiN, TaN, and W.

The gate stack separates in a lateral direction the source electrode and the drain electrode, which contact at opposite lateral sides the channel region.

Against the gate stack, dielectric sidewall spacers 24 can be formed to offset the source and drain regions from the channel region. These sidewall spacers can be formed for example from silicon-oxide, silicon-nitride, and/or silicon-carbide.

In block 302, a metal layer 14 is deposited over the substrate 11. The metal layer 14 can be comprised of nickel or nickel-based alloys. With nickel-based alloys is meant an alloy comprising about 50% or more nickel. Preferably, the metal layer 14 is nickel. The metal layer 14 can be deposited using chemical vapor deposition, sputter deposition, or other layer deposition techniques known in the art. The thickness T₁₄ of the metal layer 14 is selected to obtain after completion of the germanide-forming process a germanide layer 16 with the desired thickness T₁₆.

In block 303, a first thermal budget (as provided in a method of the invention, i.e. within the specific temperature and time ranges) is supplied to the substrate 11 during a first thermal process step. This first thermal budget is selected to form a first germanide layer 18 by reaction of the germanium in contact with the metal 14.

As disclosed by S. Gaudet et al. in "Thin film reaction of transition metals with germanium," in Journal of Vacuum Science Technology, A24 (3) May/Jun 2006, germanide phases with different metal-to-germanium ratios can be formed simultaneously at the same temperature even for thin deposited metal layers. This behavior is unlike the formation of a thin film silicide, i.e. the reaction between silicon and a transition metal, whereby different silicide phases typically form subsequently with increasing temperature.

During the thermal process step, germanium and metal diffuse to react with each-other. The pits 17 in the transition region as shown in Figure 2 indicate that germanium is transported (diffuses) from the germanium layer towards to the metal layer 14 when forming a germanide 16, 18. However, the respective diffusion process depends inter alia on the germanide phase through which the reacting species have to diffuse, the local geometry of the contacting layers, or on local stress of mechanical or thermal nature. When forming a nickel silicide, nickel will be the moving species. Thus, for thin metal layers, relevant for microelectronics processing, Ge diffusion and germanide formation in the presence of excess Ni is fundamentally different than that of Si diffusion and silicide formation in the presence of excess Ni. For this reason, Ni silicidation concepts and solutions do not necessarily apply to Ni germanidation.

The first thermal budget (as provided in a method of the invention, i.e. within the specific temperature and time ranges) is selected to convert substantially the entire deposited metal layer 14 into a germanide layer 18 in regions of the active area 12 distant from the edge 15. This first-formed germanide layer 18 should be comprised of metal-rich (NiₓGe_{y} where x > y) and mono-germanide (x = y = 1) phase(s). At least in the inner regions of the active area 12, the metal 14 deposited is substantially completely consumed leaving predominantly a metal-germanium alloy layer 18. Near the edges 15 of the active area 12, unreacted metal 14 remains, at least on the dielectric regions 13. Typically, this first germanide layer 18, comprised of metal-rich and mono-germanide phases, has a high resistivity, i.e. a resistivity higher than the resistivity of the final, predominantly mono-germanide layer 16.

The parameters of said first thermal process step, i.e. time and temperature according to a method of the invention, are selected to result in a germanide-forming process that is uniform over the exposed germanium surface, e.g. the source and drain regions 23, such that at every position in the source and drain regions 23 substantially equal amounts of germanium are consumed. The thermal budget of the first thermal step should be preferably selected (still within the limits, in particular within the preferred limits, provided in a method of the invention) to be somewhat higher than the thermal budget needed to convert, in center regions 25 offset from the edges 15, essentially all metal 14 with deposited thickness T₁₄ into a germanide.

However, the first thermal budget should not be so high (i.e. not higher than 325°C, preferably not higher than 270°C) as to result in significant germanidation high onto the sides of, or over, the dielectrics in the isolation 13 and spacer 24 regions. The level of the germanide layer 18 formed on the exposed germanium surface adjacent the germanium/dielectric border 15 should only be slightly above (if at all) the level T₁₈ of the germanide layer 18 in the center of the exposed germanium surface.

If the first thermal budget is too high (i.e. higher than 325°C), pits 17 are formed in the active germanium, as germanium from the source and drain regions 23 react non-uniformly with metal 14 high on the sides of, or over, the dielectrics 13 and 24. Additionally, this undesired, excessive germanidation near the edges 15 could result in excessive leakage currents due to insufficient isolation between adjacent active areas 12.

A limited margin on the germanide-forming process can be allowed to accommodate for variations of the metal layer 14 thickness over the wafer or for variations in the first thermal budget.

The amount of germanium present on the isolation regions 13 above the average level of the germanide layer 18 should be limited as this excess germanium amount is indicative for differences in germanium consumption between central regions and edge regions 15 of the active area 12. This first thermal budget can preferably be provided during a Rapid Thermal Processing (RTP) step.

In block 304, the unreacted metal 14 is selectively removed from the substrate 11 without affecting the germanide formed, the dielectrics exposed, or the substrate itself. Hereto, the wet etch chemicals disclosed in United States Patent No. 6,703,291, or the method of removing unreacted metal described herein can be applied.

In block 305, a second thermal budget is supplied to the substrate 11 during a second thermal process step. This second thermal budget is selected to form a second germanide layer 16 starting from the first germanide layer 18. Preferably, the germanide in this second germanide layer 16 has an overall metal-to-germanium ratio which is close to 1 and less than the ratio in the first germanide layer 18.

In this second thermal process step, the first germanide layer 18 with a higher resistivity is converted into a germanide layer 16 with a lower resistivity.

The thermal budget should be high enough to allow conversion but low enough to avoid agglomeration of the metal in the germanide layer 16. If the thermal budget is too high, the interface between the germanide layer 16 and the germanium substrate becomes rough and distorted. Likewise, the exposed surface of the germanide layer 16 will become uneven.

The thermal budget of the second thermal process step is, thus, selected to be sufficient for converting a higher resistance germanide layer 18 into a lower resistance germanide layer 16. The second thermal budget should be low enough to maintain a substantially planar interface between the second germanide layer 16 and the germanium substrate 11. When selecting the second thermal budget, care should be taken such that excessive quantities of metal of the germanide layer do not dissolve in the underlying germanium 11. This phenomenon is discussed in the case of nickel as germanide forming metal by E. Simoen et al. in "Deep level transient spectroscopy study of nickel-germanide Schottky barriers on n-type germanium," in Applied Physics. Letter. 88, 183506 (2006). In this publication, the indiffusion of nickel from the nickel-germanide region to the germanium substrate is studied as function of temperature. For temperatures up to 450°C only minor amounts of nickel would diffuse from the germanide 16 to the underlying germanium 12. This second thermal budget can preferably be provided by an Rapid Thermal Processing (RTP) step.

Figures 4a-d illustrate the process flow of Figure 3 when nickel is used as metal 14 to form a nickel germanide 16. Cross-sectional schematic views of subsequent process steps are given.

Figure 4a shows a cross-section of an integrated circuit formed on germanium substrate 11 comprising two active areas 12 separated by a dielectric region 13. One active area (right) 12 comprises a field effect transistor 19 having a stack of a gate electrode 20 and gate dielectric 21 aligned to the channel region 22. Another active area (left) 12 does not comprise a transistor. Source and drain regions 23 are formed in the active area 12 to provide electrical access to the channel region 22. Adjacent to the gate stack 20, 21, sidewall spacers 24 are formed. Edges 15 of the active area 12 with the dielectric regions 13 and 24 are indicated.

The germanium regions 12 can be isolated from each-other using the box isolation technique resulting in a trapezoid shaped dielectric region 13 above the plane of the source/drain regions 23 with a bottom angle of less than 90° or by STI isolation resulting in a trapezoid shaped dielectric region 13 extending through the plane of the source/drain regions 23 with a bottom angle of 90° or slightly above. In Figure 4a, one can distinguish two transitions from germanium 12 to dielectric material: a first transition is the edge 15 between the germanium 12 and the insulating dielectric region 13, while a second transition is the edge 15 between the germanium 12 and the dielectric spacer 24.

Figure 4b shows a cross-section of the germanium substrate 11 of Figure 4a after a nickel layer 14 has been deposited. The thickness T₁₄ of this nickel layer can be in the range of 5 to 25 nm, preferably in the range of 5 to 15 nm. Nickel can be deposited by vapor deposition or by sputtering.

Figure 4c shows a cross-section of the germanium substrate 11 of Figure 4b after first thermal processing. Nickel 14 in contact with the germanium of the active areas 12 has reacted to form a first germanide layer 18 having a thickness T₁₈ in the center 25 of the exposed germanium areas. Near 15 the dielectric regions 13, 24, the nickel layer 14 is virtually thicker than in the central exposed regions 25 of the active area 12. Indeed, part of the nickel deposited over the dielectric regions 13, 24, is available for the reaction with germanium. Moreover, the topographical steps will cause nickel to be present above the average level of the deposited nickel layer 14. Hence, germanium can diffuse to a level which is above the level of the germanide formed in the central exposed regions 25.

If excessive thermal budget is provided during this first thermal step, germanium can diffuse over the isolation regions 13, 24 even if the germanide-forming process in the central regions 25 is halted by the absence of unreacted nickel 14. As disclosed in the embodiment illustrated by Figure 3, the thermal budget of this first thermal process step is selected to have substantially all nickel react in the central regions 25. The temperature for the first thermal step can be selected as the highest temperature within the ranges provided in a method of the invention that reproducibly results in essentially no pit formation in the germanium and without undesirable germanide formation on the dielectric regions 13, 24. When selecting this temperature, the variation within the overall process, including within die, within wafer, wafer-to-wafer, and lot-to-lot must be considered to insure a robust process. It is this highest acceptable temperature that will typically result in minimal resistances. The time for this step can be selected within the ranges provided in a method of the invention that meets the above-mentioned requirements for pitting and germanide formation. Additionally, the time would typically be chosen to minimize cost per wafer by keeping process times short.

Near the edges 15 of the exposed germanium surface, the nickel germanide 18 formed can be somewhat thicker than T₁₈ in the center parts 25. This difference in germanide thickness between the border and center is preferably less than about 10%. The first thermal process step is executed during a period of nearly 0 seconds (e.g. 1 millisecond) to 600 seconds, preferably from 1 millisecond to 300 seconds, more preferably from 10 to 60 seconds.

The temperature of said first thermal budget is higher than 200°C and lower than 300°C, preferably higher than 205°C and lower than 300°C, more preferably higher than 210°C and lower than 275°C, even more preferably is comprised between 230°C and 270°C.

Typically, an RTP step in a nitrogen atmosphere is performed to form the first germanide layer 18. Typically, this first germanide layer will be comprised of metal-rich germanide phase such as Ni₅Ge₃ or Ni₂Ge and the mono-germanide NiGe.

Figure 4d shows a cross-section of the germanium substrate 11 of Figure 4c after selective wet etch and second thermal processing, resulting in the desired germanide layer 16 having a thickness T₁₆ in the center 25 of the exposed germanium areas. After removing the unreacted nickel, the germanium at the edges 15 can no longer diffuse over the dielectric regions 13, 24. The thermal budget of the second thermal step is selected to convert the high resistive first germanide layer 18 into a lower resistive second germanide layer 16.

Typically, this step takes place in an RTP in an inert ambient like nitrogen. The second thermal process step will be executed during a period of nearly 0 seconds (e.g. 1 millisecond) to 600 seconds, or nearly 0 seconds to 300 seconds, typically from 10 to 60 seconds. The temperature of this second thermal step can be in the range of 280°C to 550°C, or in the range of 300°C to 550°C. A temperature range of 325°C to 400°C is typically sufficient to substantially complete the formation of the desired Ni₁Ge₁ phase, but higher temperatures may be used if required for other reasons. Preferably, the second thermal budget has a temperature in the range from about 325°C and about 400°C and a time span of about 10 to 60 seconds.

In a preferred embodiment of the invention about 10 nm (T₁₄) of nickel 14 was sputtered on a patterned wafer 11 having active area topography. A first thermal step was performed using an RTP in a nitrogen atmosphere at about 270°C for about 30 seconds. The unreacted nickel 14 was removed selectively towards the germanide 18, the substrate 11 and the isolation region 13. Then a second thermal step was performed using an RTP in a nitrogen atmosphere at about 360°C for about 30 seconds.

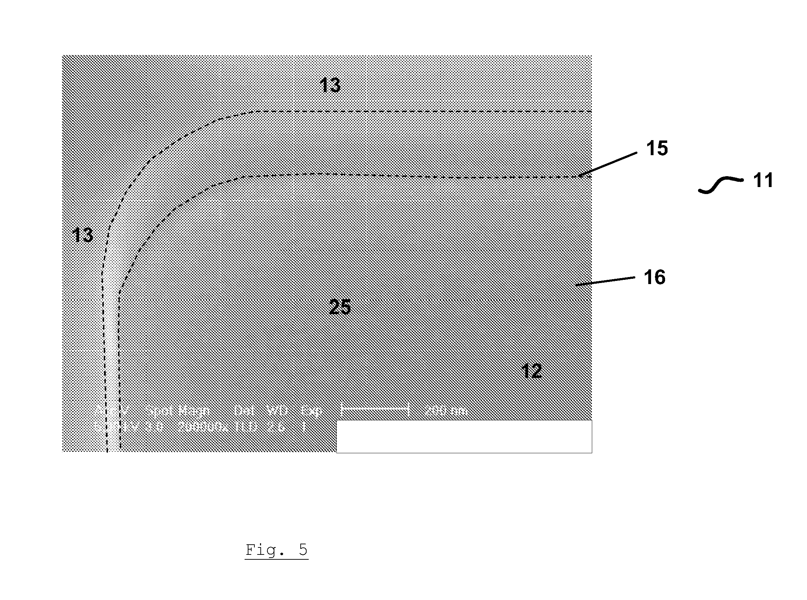

Figure 5 shows a Scanning Electron Microscope (SEM) picture of a nickel-germanide layer formed on a patterned substrate 11 according to the embodiment illustrated in Figure 4. Black dotted lines have been added to mark the contours of the dielectric region 13. No defects are seen in the active area region 12, the central region 25, or near the edge 15 with the dielectric region 13. Also, no germanide 16 is present on the dielectric region 13.

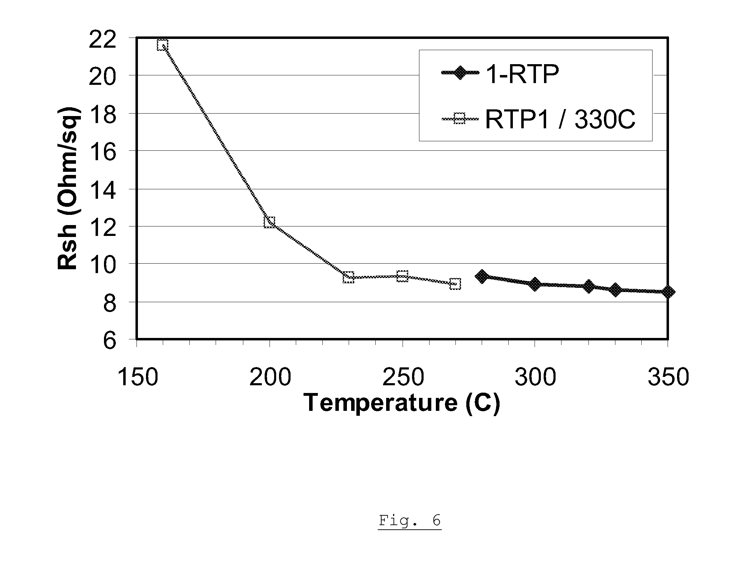

Figure 6 shows sheet resistance of germanided lines of Ni deposited on Ge as a function of RTP temperature for 30 second anneals. Sheet resistance was measured using the 4-point probe technique.

The conventional single RTP (1-RTP) germanidation process results in an increase in resistance as the temperature is dropped below 300° C. However, temperatures above 300° C have produced defects of the type shown in the SEM of Figure 2.

The figure 6 also shows resistances for the proposed 2-step RTP process, in which the first temperature is indicated by the x-coordinate on the graph and the second temperature is 330° C. These data show that a low resistance is achievable with a first process temperatures as low as 230° C. These low resistances are obtained while substantially eliminating the defects of Figure 2.

## Claims

1. A semiconductor processing method for preventing defects (or pits) in the formation of a nickel-germanide layer comprising the steps of:
- providing a substrate on which at least one area of a germanium layer is exposed;
- depositing nickel over the substrate and said germanium area;
- performing a first thermal process step by providing a first thermal budget wherein the temperature is higher than 200°C and lower than 325°C, for a time period of less than 600 seconds, whereby a germanide layer is formed;
- selectively removing unreacted nickel; and
- performing a second thermal process step for which a second thermal budget is provided to lower the resistance of the previously formed germanide layer.

2. A method according to claim 1 wherein the temperature of said first thermal budget is higher than 205°C and lower than 300°C.

3. A method according to claim 1 wherein the temperature of said first thermal budget is higher than 210°C and lower than 275°C.

4. A method according to claim 1 wherein the temperature of said first thermal budget is comprised between 230°C and 270°C.

5. A method according to any of claims 1 to 4, wherein, on said substrate, said Ge layer contacts (touches) another exposed area of a material selected from the group consisting of a dielectric material, a non-germanide forming metal such as TiN or TaN, a polymer capable of withstanding required process temperatures, and a semiconductor material different from Ge that does not react with Ni.

6. A method according to claim 5, wherein said other exposed material is a dielectric material.

7. A method according to claim 6, wherein said dielectric material is used for or in the form of a field isolation region or a spacer.

8. A method according to any of claims 1 to 7, wherein the time period of said first thermal budget is in the range of 10 seconds to 60 seconds.

9. A method according to any of claims 1 to 8, wherein said first thermal process step consists of a Rapid Thermal Process (RTP) step.

10. A method according to any of claims 1 to 8, wherein said first thermal process step is performed in a batch furnace, such as a horizontal or vertical diffusion furnace.

11. A method according to claim 9 or 10, wherein said first thermal process step is performed in an inert ambient such as nitrogen.

12. A method according to any of claims 1 to 11, wherein said nickel is pure.

13. A method according to any of claims 1 to 11, wherein said nickel is in the form of an alloy comprising at least about 50% nickel.

14. A method according to any of claims 1 to 13, wherein said second thermal process step consists of a Rapid Thermal Process (RTP) step.

15. A method according to any of claims 1 to 13, wherein said second thermal process step is performed in a batch furnace, such as a horizontal or vertical diffusion furnace.

16. A method according to any of claims 1 to 15, wherein the temperature of said second thermal budget is comprised between 280°C and 550°C.

17. A method according to any of claims 1 to 16, wherein the time period of said second thermal budget is in the range of nearly 0 second to 600 seconds.

18. A method according to claim 17, wherein the time period of said second thermal budget is in the range of 10 seconds to 60 seconds.
